# FASCICULE DE BREVET EUROPEEN

(11) **EP 2 358 808 B1**
(45) Date de publication et mention de la délivrance du brevet: **23.01.2019**
(21) Numéro de dépôt: 09802169.4
(22) Date de dépôt: 14.12.2009
(51) Int. Cl.: C08L 23/06, C08L 23/08, C09J 123/08, C09D 123/08

(54) **UTILISATION D'UN FILM COMPOSÉ DE POLYÉTHYLÉNE DANS UN MODULE PHOTOVOLTAIQUE**
VERWENDUNG EINES POLYETHYLENFILMS IN EINER SOLARZELLE
USE OF A POLYETHYLENE COMPOSITE FILM IN A SOLAR CELL ELMENT

(30) Priorité: 12.12.2008 US 122141 P; 06.02.2009 FR 0950736
(43) Date de publication de la demande: 24.08.2011
(73) Titulaire: Arkema France, 92700 Colombes (FR)
(72) Inventeur: CORFIAS ZUCCALLI, Catherine, F-27500 Pont-Audemer (FR); CARTIER, Laurent B, Montgomery PA 19087 (US); DEVISME, Samuel, F-76000 Rouen (FR); BIZET, Séphane, F-27170 BARC (FR)
(74) Mandataire: Gorintin, Sarah
(86) Numéro de dépôt international: PCT/FR2009/052517
(87) Numéro de publication internationale: WO 2010/067040

(56) Documents cités:
- WO-A-02/28974
- JP-A- 2006 032 308
- US-A- 5 593 764

## Description

### Domaine de l'invention

L'invention a pour objet un film d'une composition comprenant un mélange d'un polyéthylène choisi parmi les homopolymères de l'éthylène et les copolymères de l'éthylène et d'une autre alpha-oléfine et d'une seconde polyoléfine. L'invention porte également sur son utilisation dans les modules photovoltaïques.
L'invention porte également sur le module photovoltaïque comprenant le film de cette composition.
Un autre objet de l'invention est un procédé de fabrication de ce module ainsi que l'utilisation du module pour la fabrication d'électricité.

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

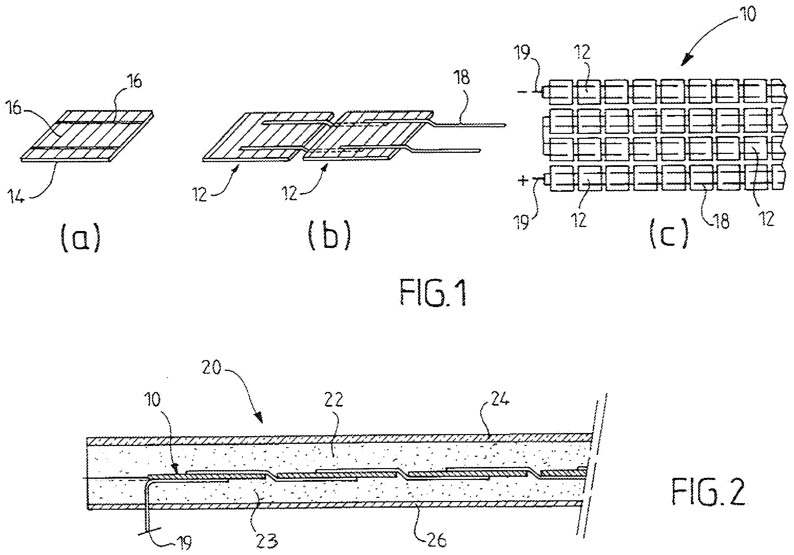

Sur la Figure 1, on a représenté une pile photovoltaïque classique; cette pile photovoltaïque (10) comprend des cellules (12), une cellule contenant un capteur photovoltaïque (14), généralement à base de silicium traité afin d'obtenir des propriétés photoélectriques, en contact avec des collecteurs d'électrons (16) placés au-dessus (collecteurs supérieurs) et au-dessous (collecteurs inférieurs) du capteur photovoltaïque. Les collecteurs (16) supérieurs d'une cellule sont reliés aux collecteurs (16) inférieurs d'une autre cellule (12) par des barres conductrices (18), constituées généralement d'un alliage de métaux. Toutes ces cellules (12) sont connectées entre elles, en série et/ou en parallèle, pour former la pile photovoltaïque (10). Lorsque la pile photovoltaïque (10) est placée sous une source lumineuse, elle délivre un courant électrique continu, qui peut être récupéré aux bornes (19) de la pile (10).
En référence à la Figure 2, le module photovoltaïque (20) comprend la pile photovoltaïque (10) de la Figure 1 enrobée dans un « encapsulant », celui-ci étant composé d'une partie supérieure (22) et d'une partie inférieure (23). Une couche protectrice supérieure (24) et une couche protectrice au dos du module (connue en anglais sous le terme « backsheet ») (26) sont disposées de part et d'autre la pile encapsulée.
L'encapsulant (22) et (23) doit épouser parfaitement la forme de l'espace existant entre la pile photovoltaïque (10) et les couches protectrices (24) et (26) afin d'éviter la présence d'air, ce qui limiterait le rendement du module photovoltaïque. L'encapsulant (22) et (23) doit également empêcher le contact des cellules (12) avec l'eau et l'oxygène de l'air, afin d'en limiter la corrosion. La partie supérieure (22) de l'encapsulant est comprise entre la pile (10) et la couche protectrice supérieure (24). La partie inférieure (23) de l'encapsulant est comprise entre la pile (10) et le backsheet (26).
La protection au choc et à l'humidité de la pile photovoltaïque (10) est assurée par la couche protectrice supérieure (24), généralement en verre.
Le backsheet (26), par exemple un film multicouche à base de polymère fluoré et de polyéthylène téréphtalate, contribue à la protection à l'humidité du module photovoltaïque (20) et à l'isolation électrique des cellules (12) pour éviter tout contact avec l'environnement extérieur.
Plus récemment, des modules photovoltaïques à couches minces ont été développés comme décrit par exemple dans la demande WO99/04971. On a représenté en Figure 3 une représentation possible de ce type de module. Cette variante de panneau photovoltaïque (21) est composée d'une couche mince d'un matériau semi-conducteur qui constitue le capteur photovoltaïque (12) sur la plaque protectrice (24). Dans ce cas, il n'y a pas d'encapsulant entre le capteur et la couche protectrice supérieure ; l'encapsulant est alors constitué uniquement d'une partie inférieure (23). Un backsheet (26) complète la structure du panneau photovoltaïque. JP-A-2006/32308 se rapporte à un mélange de un copolymère ionomer est de polyoléfine pour une espaceur dans les cellules solaires.

### Etat de l'art

Pour former un module photovoltaïque, les différentes couches (pile photovoltaïque, couche protectrice supérieure, encapsulant, backsheet) doivent adhérer à leurs différentes interfaces : dans le cas inverse, des gaz ou de l'eau s'infiltrent à l'intérieur du module, ce qui diminue le rendement du module et cause son vieillissement prématuré.

Une solution possible est d'utiliser une couche d'adhésif ou de liant entre les différentes couches. On peut par exemple citer la demande WO2004091901, qui décrit une structure de backsheet pour modules photovoltaïques, dans laquelle un adhésif à base de polyester ou de polyuréthane est compris entre une couche d'un copolymère éthylène - acétate de vinyle (EVA) et une couche d'un polymère barrière, afin de permettre l'adhérence de ces deux couches.

Une autre solution est d'utiliser un encapsulant, dont on va décrire quelques exemples dans la suite de l'état de l'art de la présente description, cet encapsulant devant présenter une adhérence avec la couche protectrice supérieure, le backsheet et la pile photovoltaïque.

En présence de rayonnement solaire, il se crée un échauffement à l'intérieur du module photovoltaïque et des températures de 70°C (ou plus) peuvent être atteintes. Les propriétés thermomécaniques, et en particulier la tenue au fluage, de l'adhésif, du liant ou de l'encapsulant doivent donc être conservées à ces températures pour que celui-ci ne soit pas déformé. La tenue au fluage est plus particulièrement importante dans le cas de l'encapsulant : en effet, en cas de fluage, la pile peut rentrer en contact avec l'air et/ou les couches protectrices supérieure et/ou inférieure, ce qui entraîne une diminution du rendement du module photovoltaïque, voire une dégradation de la pile et du module photovoltaïque.

L'encapsulant doit présenter un pouvoir d'adhésif après fabrication du panneau photovoltaïque pour éviter le délaminage des différentes couches, avoir une bonne tenue au fluage aux températures d'utilisation du panneau photovoltaïque, présenter une bonne résistivité électrique pour éviter tout court-circuit et avoir une bonne tenue à la lumière. De plus, pour ne pas diminuer le rendement du module photovoltaïque, il est nécessaire que la partie supérieure de l'encapsulant permette la transmission des ondes lumineuses du rayonnement solaire vers les cellules, c'est à dire qu'elle soit transparente. Cependant, la partie inférieure de l'encapsulant peut ne pas être transparente.

En ce qui concerne les encapsulants dans les modules photovoltaïques, l'utilisation de copolymère d'éthylène - acétate de vinyle (EVA), décrit par exemple dans la demande JP19870174967, constitue la solution la plus répandue à l'heure actuelle. L'EVA a une bonne transparence. Cependant, il se dégrade sous l'influence du rayonnement solaire et de la température ; on observe alors un dégagement d'acide acétique corrodant les cellules photovoltaïques. Par ailleurs, on remarque également un vieillissement de l'encapsulant au cours du temps, qui se matérialise notamment par un jaunissement important, conduisant à une diminution du rendement du module photovoltaïque.

En outre, la tenue au fluage de l'EVA n'est pas suffisante dans les conditions d'utilisation des modules photovoltaïques. Il est donc nécessaire que ce copolymère soit réticulé, souvent par des peroxydes ; il n'est donc plus thermoplastique.

De plus, son adhérence avec les couches protectrices n'est pas satisfaisante et des agents d'aide à l'adhérence, communément appelés « agents de couplage », doivent donc être ajoutés. Ces agents sont des produits généralement choisis parmi les silanes ou les titanates organiques.

La présence importante de ces agents de couplage peut être gênante pour le procédé de fabrication des modules photovoltaïques. En effet, les différentes couches du module sont généralement assemblées par laminage et l'assemblage des différentes couches formant le module photovoltaïque se fait généralement par sous-tirage sous vide. Ce sous-tirage sous vide est assuré par l'intermédiaire d'une membrane en silicone qui vient se plaquer contre le module photovoltaïque. Or, lors de la mise sous vide, les agents de couplage, qui sont volatils, sont aspirés et se déposent sur la membrane. Or, la silicone se dégrade au contact des agents de couplage ; il est donc nécessaire d'en supprimer ou d'en limiter leur usage afin de permettre l'utilisation de cette membrane en silicone sur une plus longue durée pour la fabrication en série de plusieurs modules photovoltaïques.

Pour résoudre les problèmes de propriétés thermomécaniques de l'encapsulant, notamment de tenue au fluage, il est décrit dans le document WO95/22843 l'utilisation comme encapsulant de ionomère dans les modules photovoltaïques. Ce ionomère est un copolymère thermoplastique, non réticulé, d'éthylène et d'acide (méth)acrylique partiellement neutralisé par des cations d'éléments des groupes I, II ou III du tableau périodique (par exemple de cation de Zinc ou de Calcium). Ces ionomères présentent également, à l'oeil nu une bonne transparence. Cependant, bien que les propriétés thermomécaniques soient meilleures que celles de l'EVA non réticulé, la tenue au fluage n'est pas suffisante. En effet, la formation d'un réseau ionique permet au ionomère de conserver une certaine cohésion au-delà de sa température de fusion mais sans que sa tenue au fluage soit pleinement satisfaisante. Un autre problème majeur du ionomère est sa viscosité élevée aux températures habituelles de fabrication des modules photovoltaïques (généralement comprises dans la gamme allant de 120°C à 160°C). Or, cette viscosité élevée est un frein à la productivité : en effet, dans un procédé continu de fabrication de film, par exemple un procédé de fabrication par extrusion, le débit de film en sortie d'extrudeuse diminue lorsque la viscosité augmente.

En outre, dans le document WO99/04971 est décrit un matériau encapsulant multicouche comprenant au moins deux couches d'un copolymère éthylène-acide méthacrylique avec une couche intermédiaire de polyéthylène métallocène. Ce matériau multicouche nécessite la fabrication par co-extrusion, ce qui nécessite des moyens de mise en oeuvre spécifiques et rend complexe son procédé de fabrication.

Par ailleurs, dans le brevet US6414236, l'encapsulant est un terpolymère éthylène -ester insaturé d'acide gras -acide gras insaturé. Cet encapsulant est destiné à améliorer la tenue au vieillissement du module photovoltaïque. Cependant, sa résistance au fluage reste médiocre et sa réticulation est donc nécessaire : l'encapsulant n'est donc plus thermoplastique. Dans les exemples, toutes les formulations comprennent des peroxydes pour réticuler les compositions.

La demande JP-A-2006/032308 a pour objet un séparateur d'électrodes utilisé pour fabriquer des cellules sensibles particulières de type Grätzel, ces cellules comprenant une solution d'électrolyte. Ce séparateur est en contact avec cette solution d'électrolyte et doit donc avoir une bonne résistance à cette solution. Cette composition n'est pas utilisée en tant que film ayant pour fonction d'encapsulant ou de backsheet.

En ce qui concerne le backsheet, il doit conférer au module photovoltaïque une imperméabilité à l'humidité, une bonne tenue au fluage et également une bonne résistance à la déchirure (c'est à dire qu'un film réalisé à partir de la composition doit présenter une bonne résistance mécanique). Il s'agit généralement de films multicouches à base de polymère fluoré (comme le polyfluorure de vinyle PVF ou le polyfluorure de vinylidène PVDF) et/ou de polyester comme du polyéthylène téréphtalate (PET).

Par exemple, la demande US 2005/0172997 décrit un module photovoltaïque dont le backsheet est un film en PVF.

La demande US 2005/0268961 décrit quant à elle une cellule photovoltaïque protégée par un film comprenant deux couches de polymère fluoré, l'une ayant une température de fusion supérieure à 135°C, l'autre ayant une température de fusion inférieure à 135°C.

On peut également citer la demande WO 2007/011580 qui décrit des films à base de polyester pour panneau arrière d'une cellule photovoltaïque. Une couche de PVF peut être associée au film de polyester.

Il est donc encore nécessaire de trouver de nouveaux modules photovoltaïques. Plus particulièrement, il est nécessaire de trouver des films pouvant être utilisés dans les modules comme encapsulant et/ou backsheet. Ces films doivent présenter une bonne adhérence aux autres couches du module et doivent présenter des propriétés suffisantes de stabilité thermomécanique à la température de fabrication du module photovoltaïque, de tenue aux UV, de tenue à la chaleur et de perméabilité à la vapeur d'eau, de propriétés électriques.

### Résume de l'invention

L'invention a justement pour objet l'utilisation d'un film de structure particulière dans un module photovoltaïque permettant de remédier aux inconvénients ci-dessus. L'invention porte sur l'utilisation dans un module photovoltaïque d'un film d'une composition en tant que backsheet ou en tant qu'encapsulant, cette composition comprenant par rapport à la masse totale de la composition :
- de 1 à 99% d'un polyéthylène ayant un taux massique d'éthylène supérieur ou égal à 80% choisi parmi les homopolymères de l'éthylène et les copolymère de l'éthylène et d'une autre alpha-oléfine ;
- de 99 à 1% d'une polyoléfine B, différente de A, portant une fonction X réactive choisie parmi les anhydrides d'acide carboxylique et les époxydes.

La composition selon l'invention combine des propriétés suffisantes d'isolation électrique, de propriétés barrière à l'eau, d'adhérence et de tenue au fluage à des températures d'utilisation de l'ordre de 100°C voire plus, même sans réticulation et sans agents de couplage ; ces propriétés intéressantes permettent son utilisation avantageuse sous forme de film dans les modules photovoltaïques en tant qu'encapsulant. De plus, la composition utilisée dans l'invention présente une meilleure tenue à la lumière et aux UV en comparaison avec l'EVA. Un autre avantage de la composition est sa faible viscosité en comparaison avec les ionomères à la température généralement utilisée pour la fabrication des panneaux photovoltaïques, ce qui facilite sa mise en oeuvre et la productivité des structures selon l'invention. De manière préférée, cette composition sera utilisée dans la partie inférieure de l'encapsulant.

Cette composition présente en outre des propriétés barrières à l'eau, de tenue au fluage à des températures d'utilisation de l'ordre de 100°C voire plus et de résistance à la déchirure lui permettant d'être utilisée en tant que backsheet. De plus, le coût de fabrication de films à partir de cette composition à base de polyoléfines est bien moindre que celui des films backsheet à base de polymères fluorés habituellement utilisés.

A notre connaissance, il n'existe pas à ce jour de solution technique permettant l'utilisation d'un film à base de polyoléfine d'une même composition comme encapsulant et backsheet. Il s'agit d'un des avantages de la présente invention qui permet de n'utiliser qu'un seul film en tant qu'encapsulant (partie inférieure) et backsheet, ce film pouvant être monocouche.

Préférentiellement, l'autre alpha-oléfine du polyéthylène A est choisie parmi le propylène, 1-butène, 1-hexène, 1-octène ou 1-décène.

Préférentiellement, la composition comprend de 10 à 75% en masse de polyéthylène A par rapport au poids total de la composition, encore plus préférentiellement 15 à 60%.

Selon un premier mode préféré de l'invention, la fonction X est une fonction anhydride d'acide carboxylique, de préférence une fonction anhydride maléique.

Selon un second mode préféré de l'invention, la fonction X est une fonction époxyde, de préférence le méthacrylate de glycidyle.

Avantageusement, le polyéthylène A comprend un taux massique supérieur ou égal à 90% d'alpha-oléfine. Préférentiellement, le polyéthylène A comprend un taux massique supérieur ou égal à 90% d'éthylène.

Avantageusement, le polyéthylène A a une densité supérieure à 0,92, préférentiellement supérieure à 0,93.

Selon une variante de l'invention, les polyoléfines de la composition sont constituées du polyéthylène A et de la polyoléfine B.

La polyoléfine B comprend préférentiellement de l'éthylène.

Avantageusement, la polyoléfine B portant la fonction X est un copolymère éthylène-(méth)acrylate d'alkyle-anhydride maléique.

Avantageusement, la polyoléfine B portant la fonction X est un copolymère éthylène - (méth)acrylate de glycidyle.

La composition peut comprendre en outre au moins un des additifs choisis parmi les agents de couplage, les agents de réticulation, les absorbants UV, les charges minérales, les plastifiants, les matières colorantes, les azurants optiques et les agents ignifugeant.

Selon un mode de l'invention, on utilise la composition comme encapsulant et backsheet.

L'invention porte également sur un module photovoltaïque qui comprend le film de la composition.

Particulièrement, on peut fabriquer le module selon un procédé comprenant :
- une étape de fabrication d'un film de la composition ;
- une étape d'assemblage des différents constituants du module avec ledit film fabriqué comme encapsulant et/ou backsheet.

Avantageusement, pour ce procédé, l'étape de fabrication du film se fait par extrusion à une température allant de 115 à 300°C, préférentiellement à une température allant de 115 à 150°C.

L'invention porte également sur l'utilisation du module photovoltaïque selon l'invention pour la production d'électricité.

### Description des Figures annexées

La description des Figures qui va suivre est donnée uniquement à titre illustratif et non limitatif en référence aux figures annexées, dans lesquelles :
La Figure 1, déjà décrite, représente un exemple de pile photovoltaïque classique, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.
La Figure 2, déjà décrite, représente une coupe transversale d'un module photovoltaïque, dont le capteur photovoltaïque « classique » est encapsulé par un film d'encapsulant supérieur et un film d'encapsulant inférieur.
La Figure 3, déjà décrite, représente une coupe transversale d'un module photovoltaïque, dont le capteur photovoltaïque de type « couche mince » déposé sur la couche de protection supérieure est encapsulé avec un film d'encapsulant inférieur.

### Description détaillée de l'invention

L'invention porte sur l'utilisation d'un film d'une composition en tant que backsheet ou en tant qu'encapsulant, ladite composition comprenant par rapport à la masse totale de la composition :
- de 1 à 99% d'un polyéthylène ayant un taux massique d'éthylène supérieur ou égal à 80% choisie parmi les homopolymères de l'éthylène et les copolymère de l'éthylène et d'une autre alpha-oléfine ;
- de 99 à 1% d'une polyoléfine B, différente de A, portant une fonction X réactive choisie parmi les anhydrides d'acide carboxylique et les époxydes.

On appelle polyoléfine des polymères comprenant comme monomère une alpha-oléfine.

Selon l'invention, lorsqu'un polymère comprend un monomère (ou un comonomère), cela signifie que ce monomère (ou ce comonomère) est polymérisé dans la chaîne polymère et il n'est plus sous la forme de monomère.

Le polyéthylène A, qui est une polyoléfine, est un polyéthylène choisi parmi les homopolymères et les copolymère de l'éthylène et d'une autre alpha-oléfine ayant un taux massique d'alpha-oléfine par exemple d'éthylène supérieur ou égal à 80%. On préfère que l'autre alpha-oléfine du polyéthylène A ait de 3 à 30 atomes de carbone.

On préfère que les alpha-oléfines de la polyoléfine B aient de 2 à 30 atomes de carbone.

A titre d'alpha-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène. On préfère le propylène et tout spécialement l'éthylène comme alpha-oléfine.

Une polyoléfine peut-être un homopolymère lorsqu'une seule alpha-oléfine est polymérisée dans la chaîne polymère.

Ces polyoléfines peuvent être aussi un copolymère lorsque au moins deux comonomères sont copolymérisés dans la chaîne polymère. L'un des comonomères est une alpha-oléfine ; l'autre ou les autres comonomères sont des monomères capables de polymériser avec l'alpha-oléfine.

Selon l'invention le mot copolymère signifie un copolymère d'une alpha-oléfine avec au moins un comonomère résultant de la polymérisation de cette alpha-oléfine et de ce(s) comonomère(s), éventuellement associé à un ou plusieurs autres co-monomères.

Comme comonomère capable de polymériser avec une alpha-oléfine, on peut citer :
- une des alpha-oléfines déjà citées, celle-ci étant différente du premier comonomère alpha-oléfine ;
- les diènes tels que par exemple le 1,4-hexadiène, l'éthylidène norbornène, le butadiène ;
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés ;
- les acides carboxyliques insaturés ou leurs sels,
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle ou le maléate de vinyle. On préfère l'acétate de vinyle comme ester vinylique d'acide carboxylique.

Le polyéthylène comprend avantageusement un taux massique supérieur ou égal à 90% d'alpha-oléfine, préférentiellement supérieur à 95%. Préférentiellement, le polyéthylène A comprend un taux massique supérieur ou égal à 90% d'éthylène, tout préférentiellement supérieur à 95%. Le polyéthylène A est avantageusement un polyéthylène moyenne densité ou haute densité, c'est à dire que la densité du polyéthylène (mesurée selon la norme ASTM D 1505) est supérieure à 0,92. De manière préférée, la densité est supérieure à 0,93. Sa température de fusion est préférentiellement supérieure ou égale à 105°C, plus préférentiellement supérieure ou égale à 110°C, de manière toute préférée supérieure ou égale à 115°C. Cette température est mesurée par DSC selon la norme ISO 11357-03.

La polyoléfine B porte une fonction X. On peut choisir comme comonomère portant la fonction X parmi :
- les anhydrides d'acide carboxylique insaturés,
- les époxydes insaturés.

Les comonomères portant une fonction anhydride d'acide carboxylique peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique.

Parmi les comonomères portant une fonction époxyde (les époxydes insaturés), on peut citer les esters et éthers de glycidyle aliphatiques tels que l'allylglycidyléther, le vinylglycidyléther, le maléate et l'itaconate de glycidyle, l'acrylate et le méthacrylate de glycidyle. Ce sont également par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate.

On préfère les anhydrides d'acide carboxylique comme fonction X (particulièrement l'anhydride maléique) ainsi que les époxydes (particulièrement le méthacrylate de glycidyle).

La polyoléfine B comprend au moins 45 % en masse d'alpha-oléfine, préférentiellement dans la gamme allant de 60% à 99% par rapport à la masse totale de la polyoléfine B.

La polyoléfine B peut comprendre jusqu'à 40% en masse de comonomère, différent de l'alpha-oléfine, ne portant pas de fonction X par rapport à la masse totale de la polyoléfine B, par exemple de 1 à 35%, préférentiellement inférieur à 20% et tout préférentiellement inférieur à 15%.

De manière préférée, la polyoléfine B est un polymère comprenant du (méth)acrylate d'alkyle. On préfère les (méth)acrylates d'alkyle dont la chaîne alkyle comprend de 1 à 4 atomes de carbone, préférentiellement le méthyle, l'éthyle ou le butyle.

La polyoléfine B peut par exemple comprendre jusqu'à 15% en masse de comonomère portant une fonction X, préférentiellement de 0,1% à 10%, tout préférentiellement de 0,5 à 5% par rapport à la masse totale de la polyoléfine B.

Selon un mode de l'invention, la polyoléfine B est un copolymère statistique d'éthylène et d'anhydride maléique ou un copolymère statistique d'éthylène, de (méth)acrylate d'alkyle et d'anhydride maléique.

Selon un autre mode de l'invention, la polyoléfine B est un copolymère statistique d'éthylène et de méthacrylate de glycidyle ou un copolymère statistique d'éthylène, de (méth)acrylate d'alkyle et de méthacrylate de glycidyle.

Le polyéthylène A peut être un copolymère d'éthylène et d'alpha-oléfine telle que par exemple le propylène, le butène-1, le héxène-1, le octène-1 ou le décène-1.

La polymérisation des monomères ou des comonomères peut être réalisée par les techniques connues de polymérisation. Elle peut être réalisée par exemple par des procédés de polymérisation radicalaire à haute pression en réacteur autoclave ou en réacteur tubulaire qui sont des techniques connues de l'homme du métier. On peut citer par exemple le brevet GB 1 090 823. D'autres procédés de copolymérisation utilisables sont par exemple ceux décrits dans US2006/0149004 A1 ou dans US2007/0032614 A1.

On peut également utiliser une polymérisation réalisée par catalyse Ziegler-Natta ou métallocène.

Pour le polyéthylène A, on préfère que ce soit un polyéthylène métallocène. Par polyéthylène métallocène, on entend un polyéthylène obtenu en utilisant un catalyseur métallocène, c'est à dire en présence d'un catalyseur mono-site constitué généralement d'un atome d'un métal pouvant être par exemple du zirconium ou du titane et de deux molécules cycliques alkyles liées au métal. Plus spécifiquement, les catalyseurs métallocènes sont habituellement composés de deux cycles cyclopentadiéniques liés au métal. Ces catalyseurs sont fréquemment utilisés avec des aluminoxanes comme cocatalyseurs ou activateurs, de préférence le méthylaluminoxane (MAO). Le hafnium peut aussi être utilisé comme métal auquel le cyclopentadiène est fixé. D'autres métallocènes peuvent inclure des métaux de transition des groupes IV A, V A, et VI A. Des métaux de la série des lanthanides peuvent aussi être utilisés.

Préférentiellement, le polyéthylène est caractérisé par un rapport *M̅w̅* / *M̅n̅* < 5, par exemple inférieur à 3 et de préférence < 2 dans lequel *M̅w̅* et *M̅n̅* désignent respectivement la masse molaire moyenne en poids et la masse molaire moyenne en nombre ou ont un MFR (Melt Flow Ratio ou rapport d'indice de fluidité) inférieur à 6,53 et un rapport *M̅w̅* / *M̅n̅* supérieur à MFR moins 4,63 ou ont un MFR égal ou supérieur à 6,13 et un rapport *M̅w̅* / *M̅n̅* inférieur ou égal à MFR moins 4,63. MFR désigne le rapport du MFI₁₀ (MFI sous une charge de 10 Kg) au MFI₂ (MFI sous une charge de 2,16 Kg).

Le comonomère qui porte une fonction X peut soit être greffé sur la polyoléfine, soit être copolymérisé avec les autres comonomères pour obtenir la polyoléfine.

Le comonomère qui porte une fonction X peut être greffé sur la polyoléfine en utilisant les techniques bien connues de l'homme du métier, par exemple le procédé de greffage en solution ou le procédé d'extrusion réactive.

Préférentiellement, le comonomère portant une fonction X est copolymérisé avec les autres comonomères.

Parmi les polyoléfines B qui viennent d'être décrites, la composition selon l'invention peut en particulier citer les copolymères vendus sous la marque Lotader® par la Demanderesse.

Préférentiellement, la composition comprend de 5 à 95% de polyéthylène A par rapport à la masse totale de la composition, préférentiellement de 10 à 60% de polyéthylène A, par exemple de 20 à 40%. Avantageusement, la composition comprend respectivement de 95 à 5% de polyoléfine B par rapport à la masse totale de la composition, préférentiellement de 90 à 40% de polyéthylène A, par exemple de 80 à 60%.

La composition a avantageusement un MFI compris dans la gamme allant de 0,1 à 80 g/10min (ASTM D 1238, 190°C, 2.16kg) et préférentiellement de 0,5 à 50g/10min. L'homme du métier peut aisément choisir le MFI de la composition en sélectionnant la quantité de chaque composant de la composition, le ratio des différents comonomères des différentes polyoléfines A et B ainsi que les masses molaires de ces polyoléfines.

Bien que la composition ait un pouvoir adhésif même en l'absence d'agents de couplage, des agents de couplage peuvent être ajoutés afin d'améliorer le pouvoir adhésif de la composition lorsque celui-ci doit être particulièrement élevé. Il peut être organique, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes. La composition peut comprendre jusqu'à 20 % en masse d'agent de couplage par rapport à la masse totale de la composition, préférentiellement de 0,1 à 10%, par exemple de 0,1 à 1%.

Bien que la présence d'agents réticulant ne soit pas obligatoire, celle-ci est possible pour encore améliorer les propriétés thermomécaniques de l'encapsulant et/ou du backsheet, en particulier lorsque la température devient très élevée. On peut citer comme exemples des isocyanates ou des peroxydes organiques. Cette réticulation peut également être réalisée par des techniques connues d'irradiation.

Le rayonnement UV entraînant un jaunissement de la composition, des stabilisants UV peuvent être ajoutés pour améliorer sa durée de vie. Ces stabilisants peuvent être par exemple à base de benzophénone ou de benzotriazole. On peut les ajouter dans des quantités inférieures à 10% en masse de la masse totale de la composition et préférentiellement de 0,1 à 5%, par exemple de 0,1 à 1%.

Parmi les charges, on donnera comme exemples la silice, l'alumine ou les carbonates de calcium, les argiles ou les nanotubes de carbone.

Des plastifiants peuvent être ajoutés afin de faciliter la mise en oeuvre et améliorer la productivité du procédé de fabrication de la composition et des films. On peut citer comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des agents retardateurs de flamme pourront également être ajoutés.

On peut également ajouter des composés colorants ou azurants.

On peut obtenir la composition selon l'invention en mélangeant les différentes polyoléfines avec les additifs éventuels en utilisant les techniques connues de mélange des matériaux thermoplastiques, comme par exemple l'extrusion ou le malaxage. On peut utiliser des mélangeurs interne à pales ou à rotors, un mélangeur externe, des extrudeuses mono-vis, bi-vis co-rotatives ou contrarotatives. On obtient alors ce qui est couramment appelé un « compound ».

L'invention porte également sur un film de la composition selon l'invention. L'épaisseur du film selon l'invention est avantageusement comprise dans la gamme allant de 50µm à 20mm.

On préfère utiliser un film ayant une épaisseur allant de 50µm à 20mm si on veut l'utiliser en tant qu'encapsulant, préférentiellement de 75µm à 10mm, de manière toute préférée de 100µm à 1mm. Toutefois, comme la composition n'a pas des propriétés de transparence aussi satisfaisantes que l'EVA, on préfère utiliser un film de la composition en tant qu'encapsulant inférieur. En revanche, cette composition présente d'excellentes propriétés d'adhérence à la couche de protection supérieure (par exemple en verre ou en PMMA). Elle présente également une excellente adhérence aux polyoléfines, particulièrement aux compositions comprenant des copolymères à base d'éthylène comme l'EVA, qui peuvent être utilisées par exemple en tant qu'encapsulant supérieur.

On préfère utiliser un film ayant une épaisseur allant de 0,2mm à 20mm si on veut l'utiliser en tant que backsheet ou encapsulant et backsheet, préférentiellement de 0,5mm à 10mm.

Le film peut être monocouche ou multicouche. Lorsqu'il est multicouche, la composition peut être associée à des couches de polymères classiquement utilisés dans le domaine photovoltaïque, tels que les polyoléfines et spécialement l'EVA, les ionomères ou les polymères fluorés.

Un film selon l'invention peut être obtenu à partir de la composition selon l'invention par les techniques classiques de pressage, d'extrusion-soufflage de gaine, d'extrusion-laminage, d'extrusion-couchage, d'extrusion à plat (encore appelée extrusion cast) ou encore par calandrage. On ne sortirait pas du cadre de l'invention si on obtenait directement le film selon l'invention sans passer par l'étape du compound.

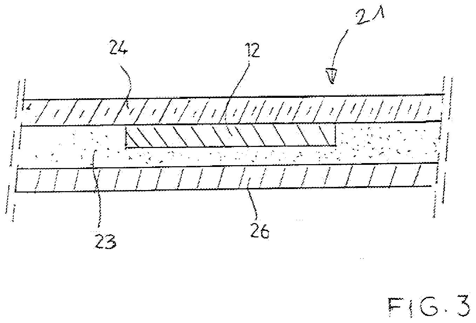

Généralement, pour former un module photovoltaïque, on place successivement sur un backsheet, une première couche d'encapsulant inférieure, une pile photovoltaïque, une seconde couche d'encapsulant supérieure puis une couche protectrice supérieure. Pour les modules photovoltaïques avec des capteurs en couche mince, on peut avoir par exemple la structure telle que décrite à la Figure 3. On peut trouver en outre des couches additionnelles entre ces couches, en particulier des couches de liants ou d'adhésifs. Ces différentes couches sont assemblées pour former le module.

Un des problèmes observés dans les modules de l'art antérieur est le délaminage à l'interface backsheet/encapsulant inférieur due à une mauvaise adhésion entre lesdits supports. Si l'adhésion est excellente entre le backsheet et l'encapsulant, on peut également observer un délaminage des couches de backsheet.

Selon l'invention, on peut utiliser un film de la composition en tant que backsheet ou en tant qu'encapsulant. Selon un mode très avantageux, la structure est utilisée en tant qu'encapsulant et backsheet, ce qui résout les problèmes de délaminage sus-mentionnés et simplifie le procédé de fabrication des modules photovoltaïques.

Il est précisé que les modules photovoltaïques selon l'invention peuvent être constitués de toute structure photovoltaïque comprenant la composition selon l'invention et ne sont bien évidemment pas limités à ceux décrits dans les Figures de la présente description.

Pour former la pile photovoltaïque, on peut utiliser tout type de capteurs photovoltaïques parmi lesquelles les capteurs dits « classiques » à base de silicium dopé, monocristallin ou polycristallin ; les capteurs en couche mince formées par exemple de silicium amorphe, de tellurure de cadnium, de disiléniure de cuivre-indium ou de matériaux organiques peuvent également être utilisés.

La plaque protectrice a des propriétés de résistance à l'abrasion et au choc, est transparente et protège les capteurs photovoltaïques de l'humidité extérieure. Pour former cette couche, on peut citer le verre, le PMMA ou toute autre composition polymère réunissant ces caractéristiques.

Pour assembler les différentes couches, on peut utiliser tous les types de techniques de pressage comme par exemple le pressage à chaud, le pressage sous vide ou le laminage, en particulier le laminage à chaud. Les conditions de fabrication seront aisément déterminées par l'homme du métier en ajustant la température et la pression à la température d'écoulement de la composition.

Pour fabriquer les modules photovoltaïques selon l'invention, l'homme du métier peut se référer par exemple au Handbook of Photovoltaic Science and Engineering, Wiley, 2003*.*

La présente invention va être maintenant illustrée par des exemples démontrant les avantages de la présente invention. Il est précisé que ces exemples ne visent en aucun cas à limiter la portée de la présente invention.

### Exemples

Pour formuler les exemples de l'invention et comparatifs, les produits suivants ont été utilisés :
1020 FN 24: PE moyenne densité produit par Total Petrochemicals de densité égale 0,922g/cm³ de MFI égal à 2,1/10min (ASTM D 1238, 190°C, 2.16kg) et dont la température de fusion est égale 109°C.
M 3410 EP : PE métallocène moyenne densité produit par Total Petrochemicals de densité égale 0,934g/cm³ de MFI égal à 0,9g/10min (ASTM D 1238, 190°C, 2.16kg) et dont la température de fusion est égale 124°C.
Lotader® 6200 : Copolymère d'éthylène, d'acrylate d'éthyle (6,5 % en poids) et d'anhydride maléique (2,8 % en poids) produit par ARKEMA possédant un MFI de 40g/10mn (ASTM D 1238, 190°C, 2,16 kg) et une température de fusion égale à 102°C.
Verre : Plaques de 3 mm
Backsheet : Film multicouche PVF/PET/PVF dont la surface du PVF est traitée avec un enduit.
EVA : Copolymère d'éthylène et d'acétate de vinyle comprenant 33% d'acétate de vinyle en poids, ayant un MFI de 45 g/10mn (ASTM D 1238, 190°C, 2,16 kg) et une température de fusion égale à 62°C.

Afin d'évaluer les propriétés des différentes formulations selon l'invention, des films ont été extrudés par la technologie cast dans une extrudeuse OCS ayant une vitesse de vis de 85 tours/min. On réalise avant l'extrusion un mélange en sac des différents composants dans les proportions du Tableau 1, ce mélange en sac étant introduit dans la trémie. Les températures des 4 zones chauffantes sont réglées vers 125°C/125°C/125°C/133°C, la formulation fondue en tête de l'extrudeuse passe dans une filière plate à 125°C permettant la formation des films d'environ 0,5mm sur le cylindre en sortie d'extrudeuse.

Des films de formulations comparatives d'EVA sont produits selon le même protocole.

**Tableau 1**

| **Composition** | **Lotader 6200** | **1020 FN24** | **M 3410 EP** |
|---|---|---|---|
| **1** | 70 | | 30 |
| **2** | 50 | | 50 |
| **3** | 30 | | 70 |
| **4** | 50 | 50 | |

Les résultats concernant la perméabilité des films obtenus sont reportés Tableau 2 (en anglais Moisture Vapor Transmission Rate - MVTR). Les essais sont réalisés suivant la norme DIN 53122 (méthode E, 23°C, 85% HR). La méthode consiste à mettre un déshydratant (chlorure de calcium anhydre) dans une coupelle recouverte d'un film de la formulation à évaluer. L'ensemble est scellé et placé dans une enceinte ventilée régulée en température (23°C) et en humidité relative (85% HR). Des pesées périodiques permettent de déterminer la quantité de vapeur d'eau qui diffuse au travers du film. Les formulations ont été testées en perméabilité sans conditionnement particulier. Pour chaque formulation, 3 essais ont été réalisés.

Pour évaluer le pouvoir adhésif des formulations, on a fabriqué par pressage des structures constituées de 3 couches verre/formulation/backsheet.

Après un nettoyage préalable du verre à l'alcool, la structure comprenant les couches successives de verre, de formulation et de backsheet est placée sous une presse chauffante de type COLLIN P 400 P.

Les conditions de pressage sont les suivantes : début de pressage à 110 °C sous 3 bar, rampe de température à 4°C/min pour augmenter la température à 150°C, maintien sous 3 bar pendant 15 min à 150°C, puis rampe à une vitesse de 8°C/min pour baisser la température à 110°C suivi du retrait de la structure finie et refroidissement à température ambiante.

Le pouvoir adhésif de la formulation est évalué par un test de pelage à 90° selon la norme IS08510-1. La structure obtenue est refroidie à température ambiante, et sa résistance au pelage est mesurée 6 jours après fabrication en les stockant à 23°C et un taux d'humidité HR de 50%. Pour chaque formulation, 4 essais ont été réalisés. La force de pelage et l'aspect de la rupture sont également reportés Tableau 2. Un aspect à la rupture adhésif montre une adhésion moins importante qu'une rupture cohésive. Le délaminage du backsheet montre également une excellente adhésion du liant au backsheet et au verre.

**Tableau 2**

| **Composition** | **MVTR (g.25µm/m2.24h)** | **Force de pelage (N/15 mm)** | **Aspect de la rupture** |
|---|---|---|---|
| **EVA** | 400 | 2 | adhésive |
| **1** | 10 | 12,5 | adhésive |
| **2** | 7,95 | 19 | cohésive |
| **3** | 5,3 | 19 | adhésive et cohésive |
| **4** | 9 | 29,5 | délaminage du backsheet |

Toutes les formulations selon l'invention montrent d'excellentes valeurs de perméabilité à la vapeur d'eau et des forces de pelage élevées en comparaison avec les encapsulants EVA classiquement utilisés. Ces meilleures propriétés lui permettent de mieux protéger le panneau photovoltaïque de l'humidité tout en évitant le délaminage des différentes couches, ce qui permet d'améliorer la durée de vie des modules photovoltaïques.

Pour mesurer la tenue au fluage, on a réalisé pour chaque échantillon une éprouvette ayant 50 mm de longueur, 4,15 mm de largeur et 1 mm d'épaisseur sous presse chauffante à 125°C pendant 20 minutes.

A chaque éprouvette, on applique un poids en bas de l'éprouvette correspondant à une contrainte de 0,5 bar. On place les éprouvettes dans une enceinte à température contrôlée. Le test démarre à 85°C. On mesure le fluage en relevant si l'éprouvette casse pendant le test ou en mesurant son allongement éventuel. Si les éprouvettes ne cassent pas à cette température, le test est reproduit à une température plus élevée de 10°C, jusqu'à une température maximale de 125°C.

Les résultats de fluage sont reportés Tableau 3.

**Tableau 3**

| **Formulation** | **résultats fluage** | | | | |
|---|---|---|---|---|---|
| | **85°C** | **95°C** | **105°C** | **115°C** | **125°C** |
| **EVA** | <1 min | | | | |
| **1** | OK | OK | OK | OK | 4 min |
| **2** | OK | OK | OK | OK | 5 min |
| **3** | OK | OK | OK | OK | 5 min |
| **4** | OK | OK | 5 min | | |

- Notation OK : l'éprouvette en question résiste à la température considérée (pas d'élongation sous charge après 15 minutes).
- Notation de type x min : à cette température, l'éprouvette ne tient que quelques minutes. Elle flue puis il y a rupture totale après x minutes.
- Notation de type all 120%, all 140% etc... : à cette température, l'éprouvette flue dans un premier temps, puis l'allongement reste constant et l'éprouvette ne casse pas lors du test.

Les formulations non réticulées selon l'invention présentent une bien meilleure tenue au fluage que l'EVA. Ce niveau de tenue au fluage permet aux formulations selon l'invention d'être utilisées dans les panneaux photovoltaïques sans réticulation. Un autre avantage d'un mode de l'invention est la tenue au fluage améliorée lorsque la polyoléfine A est métallocène.

## Revendications

1. Utilisation en tant que backsheet ou en tant qu'encapsulant dans un module photovoltaïque d'un film d'une composition, cette composition comprenant par rapport à la masse totale de la composition :
• de 1 à 99% d'un polyéthylène A ayant un taux massique d'éthylène supérieur ou égal à 80% choisie parmi les homopolymères de l'éthylène et les copolymères de l'éthylène et d'une autre alpha-oléfine;
• de 99 à 1% d'une polyoléfine B, différente de A, portant une fonction X réactive choisie parmi les anhydrides d'acide carboxylique et les époxydes.

2. Utilisation selon la revendication 1 **caractérisée en ce que** l'autre alpha-oléfine du polyéthylène A est choisie parmi le propylène, 1-butène, 1-hexène, 1-octène ou 1-décène.

3. Utilisation selon la revendication 1 ou 2 **caractérisée en ce qu'**elle comprend de 10 à 75% en masse de polyoléfine A par rapport au poids total de la composition.

4. Utilisation selon l'une des revendications 1 à 3 **caractérisée en ce que** la fonction X est une fonction anhydride d'acide carboxylique, de préférence une fonction anhydride maléique.

5. Utilisation selon l'une des revendications 1 à 3 **caractérisée en ce que** la fonction X est une fonction époxyde, de préférence le méthacrylate de glycidyle.

6. Utilisation selon l'une des revendications 1 à 5 **caractérisée en ce que** le polyéthylène A comprend un taux massique supérieur ou égal à 90% d'éthylène.

7. Utilisation selon l'une des revendications 1 à 6 **caractérisée en ce que** le polyéthylène A a une densité supérieure à 0,92, préférentiellement supérieure à 0,93.

8. Utilisation selon l'une des revendications 1 à 7 **caractérisée en ce que** la polyoléfine B comprend de l'éthylène.

9. Utilisation selon l'une des revendications 1 à 8 **caractérisée en ce que** la polyoléfine B portant la fonction X est un copolymère éthylène-(méth)acrylate d'alkyle-anhydride maléique.

10. Utilisation selon l'une des revendications 1 à 9 **caractérisée en ce qu'**elle comprend en outre au moins un des additifs choisis parmi les agents de couplage, les agents de réticulation, les absorbants UV, les charges minérales, les plastifiants, les matières colorantes, les azurants optiques et les agents ignifugeant.

11. Module photovoltaïque comprenant un film utilisé selon l'une des revendications 1 à 10 d'une composition, dans laquelle la composition est telle que définie selon l'une quelconque des revendications 1 à 10.

12. Procédé de fabrication d'un module selon la revendication 11 comprenant :
• une étape de fabrication d'un film utilisé dans l'une des revendications 1 à 10;
• une étape d'assemblage des différents constituants du module avec ledit film fabriqué comme encapsulant et/ou backsheet.

13. Utilisation du module selon la revendication 11 pour la production d'électricité.

## Patentansprüche

1. Verwendung als Rückschicht oder als Verkapselungsmittel in einem Photovoltaikmodul einer Folie mit einer Zusammensetzung, wobei die Zusammensetzung relativ zum Gesamtgewicht der Zusammensetzung Folgendes umfasst:
• 1 bis 99% eines Polyethylens A mit einem Ethylengewichtsanteil von mehr oder gleich 80%, ausgewählt aus Homopolymeren von Ethylen und Copolymeren von Ethylen und einem anderen Alpha-Olefin;
• 99 bis 1% eines von A verschiedenen Polyolefins B, das eine reaktive Funktion X trägt, ausgewählt aus Carbonsäureanhydriden und Epoxiden.

2. Verwendung nach Anspruch 1, **dadurch gekennzeichnet, dass** das andere Alpha-Olefin des Polyethylens A ausgewählt wird aus Propylen, 1-Buten, 1-Hexen, 1-Octen oder 1-Decen.

3. Verwendung nach Anspruch 1 oder 2, **dadurch gekennzeichnet, dass** sie von 10 bis 75 Gew.-% Polyolefin A umfasst, bezogen auf das Gesamtgewicht der Zusammensetzung.

4. Verwendung nach einem der Ansprüche 1 bis 3, **dadurch gekennzeichnet, dass** die Funktion X eine Carbonsäureanhydridfunktion ist, vorzugsweise eine Maleinsäureanhydridfunktion.

5. Verwendung nach einem der Ansprüche 1 bis 3, **dadurch gekennzeichnet, dass** die Funktion X eine Epoxidfunktion ist, vorzugsweise Glycidylmethacrylat.

6. Verwendung nach einem der Ansprüche 1 bis 5, **dadurch gekennzeichnet, dass** das Polyethylen A einen Gewichtsanteil von mehr als oder gleich 90% Ethylen umfasst.

7. Verwendung nach einem der Ansprüche 1 bis 6, **dadurch gekennzeichnet, dass** das Polyethylen A eine Dichte von mehr als 0,92 aufweist, vorzugsweise mehr als 0,93.

8. Verwendung nach einem der Ansprüche 1 bis 7, **dadurch gekennzeichnet, dass** das Polyolefin B Ethylen umfasst.

9. Verwendung nach einem der Ansprüche 1 bis 8 **dadurch gekennzeichnet, dass** das Polyolefin B, das die Funktion X trägt, ein Ethylen-Alkyl-(meth)acrylat-Maleinsäureanhydrid-Copolymer ist.

10. Verwendung nach einem der Ansprüche 1 bis 9, **dadurch gekennzeichnet, dass** sie ferner mindestens ein Additiv umfasst, ausgewählt aus Kupplungsmitteln, Vernetzungsmitteln, UV-Absorbern, mineralischen Füllstoffen, Weichmachern, Farbstoffen, optischen Aufhellern und Flammschutzmitteln.

11. Photovoltaikmodul, das eine Folie einer Zusammensetzung umfasst, die nach einem der Ansprüche 1 bis 10 verwendet wird, in der die Zusammensetzung wie nach einem der Ansprüche 1 bis 10 definiert ist.

12. Verfahren zur Herstellung eines Moduls nach Anspruch 11, das Folgendes umfasst:
• einen Schritt zum Herstellen einer Folie verwendet nach einem der Ansprüche 1 bis 10;
• einen Schritt des Zusammenbaus verschiedener Bestandteile des Moduls mit der hergestellten Folie als Verkapselungsmittel und/oder Rückschicht.

13. Verwendung des Moduls nach Anspruch 11 zur Erzeugung von Elektrizität.

## Claims

1. Use as backsheet or as encapsulant in a photovoltaic module of a film of a composition, this composition comprising, with respect to the total weight of the composition:
• from 1 to 99% of a polyethylene A having a level by weight of ethylene of greater than or equal to 80% chosen from ethylene homopolymers and copolymers of ethylene and of another α-olefin;
• from 99 to 1% of a polyolefin B, other than A, carrying a reactive functional group X chosen from carboxylic acid anhydrides and epoxides.

2. Use according to Claim 1, **characterized in that** the other α-olefin of the polyethylene A is chosen from propylene, 1-butene, 1-hexene, 1-octene or 1-decene.

3. Use according to Claim 1 or 2, **characterized in that** it comprises from 10 to 75% by weight of polyolefin A, with respect to the total weight of the composition.

4. Use according to one of Claims 1 to 3, **characterized in that** the functional group X is a carboxylic acid anhydride functional group, preferably a maleic anhydride functional group.

5. Use according to one of Claims 1 to 3, **characterized in that** the functional group X is an epoxide functional group, preferably glycidyl methacrylate.

6. Use according to one of Claims 1 to 5, **characterized in that** the polyethylene A comprises a level by weight of ethylene of greater than or equal to 90%.

7. Use according to one of Claims 1 to 6, **characterized in that** the polyethylene A has a density of greater than 0.92, preferably of greater than 0.93.

8. Use according to one of Claims 1 to 7, **characterized in that** the polyolefin B comprises ethylene.

9. Use according to one of Claims 1 to 8, **characterized in that** the polyolefin B carrying the functional group X is an ethylene-alkyl (meth)acrylate-maleic anhydride copolymer.

10. Use according to one of Claims 1 to 9, **characterized in that** it additionally comprises at least one of the additives chosen from coupling agents, crosslinking agents, UV absorbents, inorganic fillers, plasticizers, colouring materials, optical brighteners and flame retardants.

11. Photovoltaic module comprising a film according to one of Claims 1 to 10 used of a composition, in which the composition is as defined according to any one of Claims 1 to 10.

12. Process for the manufacture of a module according to Claim 11, comprising:
• a stage of manufacturing a film used in one of Claims 1 to 10;
• a stage of assembling the various constituents of the module with the said manufactured film as encapsulant and/or backsheet.

13. Use of the module according to Claim 11, for the production of electricity.
